# EUROPÄISCHE PATENTSCHRIFT

(11) **EP 3 123 247 B1**
(45) Veröffentlichungstag und Bekanntmachung des Hinweises auf die Patenterteilung: **30.12.2020**
(21) Anmeldenummer: 15738586.5
(22) Anmeldetag: 11.03.2015
(51) Int. Cl.: G03F 7/20, G01J 4/00, G01M 11/02

(54) **MESSVORRICHTUNG ZUM BESTIMMEN EINES POLARISATIONSPARAMETERS**
MEASURING DEVICE FOR DETERMINING A POLARISATION PARAMETER
DISPOSITIF DE MESURE SERVANT À DÉTERMINER UN PARAMÈTRE DE POLARISATION

(30) Priorität: 24.03.2014 DE 102014205406
(43) Veröffentlichungstag der Anmeldung: 01.02.2017
(73) Patentinhaber: Carl Zeiss SMT GmbH, 73447 Oberkochen (DE)
(72) Erfinder: WIRSING, Andreas, 73431 Aalen (DE)
(74) Vertreter: Zeuner Summerer Stütz
(86) Internationale Anmeldenummer: PCT/EP2015/000537
(87) Internationale Veröffentlichungsnummer: WO 2015/144291

(56) Entgegenhaltungen:
- DE-A1-102008 001 448
- US-A1- 2010 045 956
- US-A1- 2011 032 502
- MICHAEL TOTZECK ET AL: "Orientation Zernike polynomials: a useful way to describe the polarization effects of optical imaging systems", JOURNAL OF MICRO/NANOLITHOGRAPHY, MEMS AND MOEMS, Bd. 8, Nr. 3, 5. August 2009 (2009-08-05), Seite 031404, XP055210837, ISSN: 1932-5150, DOI: 10.1117/1.3173803 in der Anmeldung erwähnt

## Beschreibung

### Hintergrund der Erfindung

Die Erfindung betrifft eine Messvorrichtung sowie eine Verfahren zum Bestimmen eines Polarisationsparameters eines optischen Systems. Weiterhin betrifft die Erfindung eine Projektionsbelichtungsanlage für die Mikrolithographie mit einer derartigen Messvorrichtung.

In US 7,286,245 B2 ist ein Verfahren zum Bestimmen eines Einflusses eines optischen Systems auf den Polarisationszustand optischer Strahlung beschrieben. Mit diesem Verfahren wird eine Jones Matrix des optischen Systems in zwei Messstufen ermittelt. In der ersten Messstufe wird eingangsseitige Strahlung definierter Polarisationszustände nacheinander auf das optische System eingestrahlt. Die Intensitäten der resultierenden ausgangsseitigen Polarisationszustände der aus dem optischen System austretenden Strahlung werden daraufhin unter Verwendung eines Polarisationsanalysators gemessen. Daraus wird eine phasenreduzierte Jones-Matrix berechnet. In einer zweiten Messstufe wird mittels interferometrischer Messung ein globaler Phasenterm bestimmt. Die in der ersten Messstufe bestimmte phasenreduzierte Jones-Matrix wird daraufhin mit dem globalen Phasenterm kombiniert, um die vollständige Jones-Matrix des optischen Systems zu erhalten.

Aus der Jones-Matrix können Polarisationsparameter, wie etwa die Retardation, bestimmt werden. Ändern sich jedoch die Umweltbedingungen während des vorstehend beschriebenen Messverfahrens, so kann das Messergebnis dadurch verfälscht werden.

Weitere Messvorrichtungen zum Bestimmen eines Polarisationsparameters eines optischen Systems sind offenbart in DE102008001448 A1 und in US2011032502 A1.

### Zugrunde liegende Aufgabe

Es ist eine Aufgabe der Erfindung, eine Messvorrichtung sowie ein Verfahren zum Bestimmen eines Polarisationsparameters bereitzustellen, womit die vorgenannten Probleme gelöst werden, und insbesondere Einflüsse von sich ändernden Umweltbedingungen und/oder im Zeitverlauf auftretenden Instabilitäten auf das Messergebnis minimiert werden.

### Erfindungsgemäße Lösung

Die vorstehende Aufgabe kann erfindungsgemäß beispielsweise mit der nachstehend beschriebenen Messvorrichtung zum Bestimmen eines Polarisationsparameters eines optischen Systems gelöst werden. Diese Messvorrichtung umfasst ein Beleuchtungssystem zum Bereitstellen einer optischen Strahlung, eine Messmaske, welche zwischen dem Beleuchtungssystem und dem optischen System angeordnet ist und Messstrukturen aufweist, die an mehreren Feldpunkten der Messmaske angeordnet sind. Weiterhin umfasst die Messvorrichtung eine Polarisationsvariationseinrichtung, welche in einem Strahlengang der optischen Strahlung angeordnet ist und dazu konfiguriert ist, einen Polarisationszustand der optischen Strahlung feldpunktabhängig zu variieren, sodass zum gleichen Zeitpunkt einer der Feldpunkte mit der optischen Strahlung in einem ersten Polarisationszustand und ein weiterer der Feldpunkte mit der optischen Strahlung in einem zweiten Polarisationszustand bestrahlt wird. Darüber hinaus weist die Messvorrichtung ein Erfassungsmodul auf, welches dazu konfiguriert ist, die optische Strahlung nach Wechselwirkung mit dem optischen System zu erfassen.

Das als Messobjekt der erfindungsgemäßen Messvorrichtung dienende optische System kann ein optisches System einer Projektionsbelichtungsanlage für die Mikrolithographie, insbesondere ein Projektionsobjektiv einer solchen Projektionsbelichtungsanlage sein. Das Beleuchtungssystem ist insbesondere dazu konfiguriert, die optische Strahlung in einem definierten Polarisationszustand bereitzustellen.

Der Polarisationsparameter betrifft einen Parameter, welcher eine polarisationsbezogene Wechselwirkung optischer Strahlung mit dem optischen System beschreibt. Der Polarisationsparameter kann dabei eine durch das optische System erfolgende Beeinflussung einer Polarisationseigenschaft der optischen Strahlung definieren. Beispiele für derartige Polarisationsparameter sind die Retardation, der lineare Dichroismus, die Rotation sowie der Zirkulardichroismus. Weiterhin kann der Polarisationsparameter eine Polarisationsabhängigkeit eines Abbildungsfehlers des optischen Systems definieren. Ein derartiger Abbildungsfehler kann beispielsweise ein Verzeichnungsfehler oder ein Fokuslagenfehler des optischen Systems sein. Ein Verzeichnungsfehler verursacht eine Veränderung von relativen Positionen von Messstrukturen auf der Messmaske zueinander bei Abbildung mittels des optischen Systems auf ein Substrat. Ein derartiger Verzeichnungsfehler wird oft auch als "Overlay-Fehler" bezeichnet.

Das Erfassungsmodul kann weiterhin dazu konfiguriert sein, den Polarisationsparameter aus der erfassten optischen Strahlung zu ermitteln. Alternativ kann der Polarisationsparameter auch separat ermittelt werden. Beispielsweise kann bei Bestimmung eines Verzeichnungsfehlers mittels direkter Overlay-Messtechnik das Erfassungsmodul ein zu belichtender Wafer sein. Nach Belichtung des Wafers kann dieser dann mit einem geeigneten Mikroskop, wie etwa einem Elektronenmikroskop bezüglich der Verzeichnungsfehler untersucht werden.

Der vorstehend genannte erste Polarisationszustand unterscheidet sich vom zweiten Polarisationszustand. Mit anderen Worten ist die Polarisationsvariationseinrichtung dazu konfiguriert den Polarisationszustand der optischen Strahlung derart zu variieren, sodass mindestens zwei der Feldpunkte zum gleichen Zeitpunkt mit der optischen Strahlung in unterschiedlichen Polarisationszuständen bestrahlt werden. Die Polarisationsvariationseinrichtung kann als zusammenhängendes Element ausgebildet sein oder auch mehrere Elemente umfassen. Gemäß einer Ausführungsform ist die Polarisationsvariationseinrichtung zwischen dem Beleuchtungssystem und der Messmaske angeordnet. Alternativ kann die Polarisationsvariationseinrichtung auch im Strahlengang innerhalb des Beleuchtungssystems angeordnet sein.

Die Polarisationsvariationseinrichtung der Messvorrichtung ermöglicht es, mehrere Messkanäle durch das optische System zeitgleich mit unterschiedlichen Polarisationszuständen zu beaufschlagen und damit die Messung des Polarisationsparameters in einem zeitlich eng begrenzten Messvorgang durchzuführen. Damit können Einflüsse von sich ändernden Umweltbedingungen und/oder im Zeitverlauf auftretenden Instabilitäten auf das Messergebnis minimiert werden.

Gemäß einer Ausführungsform der Messvorrichtung weist die Polarisationsvariationseinrichtung mindestens ein Polarisationsrotationselement zur Drehung der eingestrahlten optischen Strahlung auf. Insbesondere weist die Polarisationsvariationseinrichtung mehrere Polarisationsrotationselemente mit unterschiedlichen Rotationswinkeln, vorzugsweise vier Polarisationselemente mit den Rotationswinkeln 0°, 45°, 90° und 135° auf. Die Polarisationsrotationselemente können als Halbwellenplatten ausgebildet sein. Alternativ können die Polarisationselemente optisch aktive Substanzen aufweisen.

Die Polarisationsvariationseinrichtung weist Orte auf, welche im Strahlengang der optischen Strahlung den Feldpunkten auf der Messmaske zugeordnet sind. Jeweils eines der vorgenannten Polarisationsrotationselemente unterschiedlicher Rotationswinkel ist an einem der den Feldpunkten zugeordneten Orte der Polarisationsvariationseinrichtung angeordnet. Damit wird jeder der Feldpunkte auf der Messmaske mit optischer Strahlung bestrahlt, welche sich jeweils hinsichtlich des Rotationswinkels ihrer Polarisationsrichtung von Strahlung unterscheidet, welche auf einen anderen der Feldpunkte auf der Messmaske eingestrahlt wird.

Gemäß einer weiteren Ausführungsform weist die Polarisationsvariationseinrichtung mindestens eine Halbwellenplatte auf. Insbesondere weist die Polarisationsvariationseinrichtung mehrere Halbwellenplatten mit unterschiedlich ausgerichteten optischen Achsen auf. Beispielsweise umfasst die Polarisationsvariationseinrichtung vier Halbwellenplatten mit den folgenden Ausrichtungen der optischen Achsen gegenüber der Polarisationsrichtung der eingestrahlten optischen Strahlung: 0°, 22,5°, 45°, 67,5°. Daraus ergeben sich Drehungen der Polarisationsrichtung der eingestrahlten optischen Strahlung um die folgenden Rotationswinkel: 0°, 45°, 90° und 135°.

Gemäß einer weiteren Ausführungsform weist die Polarisationsvariationseinrichtung mindestens eine Viertelwellenplatte auf. Insbesondere umfasst die Polarisationsvariationseinrichtung mehrere Viertelwellenplatten mit unterschiedlich ausgerichteten optischen Achsen. Gemäß einer Ausführungsform schließen die optischen Achsen zweier Viertelwellenplatten einen Winkel von 90° ein. Insbesondere sind diese Viertelwellenplatten so ausgerichtet, dass deren optischen Achsen mit der Polarisationsrichtung der in einem linear polarisierten Zustand eingestrahlten optischen Strahlung einen +45° sowie einen -45° Winkel einschließen. Mit einer derartigen Polarisationsvariationseinrichtung können zirkular polarisierte Strahlungszustände auf das optische System eingestrahlt werden und damit als Polarisationsparameter z.B. ein Zirkulardichroismus und/oder eine Rotation des optischen Systems bestimmt werden. Unter einem zirkular polarisierten Zustand wird ein Zustand verstanden, in dem die optische Strahlung überwiegend zirkular polarisierte Strahlungskomponenten umfasst.

Gemäß der Erfindung sind die Messstrukturen in mehreren Messfeldern angeordnet und die Polarisationsvariationseinrichtung ist dazu konfiguriert, den Polarisationszustand der optischen Strahlung innerhalb jedes der Messfelder mit dem gleichen Variationsmuster feldpunktabhängig zu variieren. Mit anderen Worten erfolgt in jedem der mehrere Feldpunkte umfassenden Messfelder eine Bestrahlung mit der gleichen örtlichen Polarisationsverteilung.

Gemäß einer weiteren Ausführungsform ist die Polarisationsvariationseinrichtung an der Messmaske befestigt ist. Mit anderen Worten bilden die Messmaske und die Polarisationsvariationseinrichtung zusammen ein einheitliches Messmodul, zum Beispiel in Gestalt eines einheitlichen Messretikels.

Gemäß einer weiteren Ausführungsform ist die Messvorrichtung als Wellenfrontmessvorrichtung konfiguriert. Eine derartige Wellenfrontmessvorrichtung kann ein Interferometer, wie etwa ein Scherinterferometer oder ein Punktbeugungsinterferometer, umfassen.

Gemäß einer weiteren Ausführungsform umfasst das Erfassungsmodul ein Beugungsgitter. Mit einem derartigen Beugungsgitter kann die Messvorrichtung als Interferometer betrieben werden.

Gemäß einer weiteren Ausführungsform sind die Messstrukturen jeweils gitterförmig konfiguriert. Für Verzeichnungsfehlermessung können die Messstrukturen auch anders geartet sein. Beispielsweise können sie für diese Verwendung in Gestalt von Kreuzen ausgebildet sein.

Gemäß einer weiteren Ausführungsform ist das Beleuchtungssystem dazu konfiguriert, die optische Strahlung nacheinander in unterschiedlichen Polarisationszuständen bereitzustellen. Gemäß einer Ausführungsvariante umfassen die unterschiedlichen Polarisationszustände linear polarisierte Polarisationszustände unterschiedlicher Orientierungen. Unter einem linear polarisierten Zustand wird ein Zustand verstanden, in dem die optische Strahlung überwiegend linear polarisierte Strahlungskomponenten umfasst.

Die nacheinander erfolgende Einstrahlung der optischen Strahlung in unterschiedlichen Polarisationszuständen kann der Kalibrierung der Messvorrichtung dienen. Hierbei können die innerhalb eines Messfeldes angeordneten Messkanäle hinsichtlich ihrer Polarisationsabhängigkeit kalibriert werden. Messfelder in diesem Zusammenhang umfassen Bereiche auf der Messmaske, in denen jeweils eine bestimmte Anzahl an Messstrukturen angeordnet ist. Dabei ist die Polarisationsvariationseinrichtung dazu konfiguriert, den Polarisationszustand innerhalb jedes der Messfelder mit dem gleichen Variationsmuster feldpunktabhängig zu variieren.

Mit anderen Worten kann durch Einstrahlung unterschiedlicher Polarisationszustände das Variationsmuster der Polarisation innerhalb eines Messfeldes, in welchem mehrere Messstrukturen angeordnet sind, variiert werden. Durch Vergleich der Messergebnisse des Polarisationsparameters für die einzelnen Messfelder bei den unterschiedlichen Variationsmustern kann überprüft werden, ob die Messvorrichtung polarisationsunabhängig ist. Falls dies der Fall ist, sollte für jedes der Messfelder bei Einstrahlung der unterschiedlichen Polarisationszustände der gleiche Wert für den Polarisationsparameter resultieren. Ergeben sich die gleichen Werte für den Polarisationsparameter, dann kann die Annahme zugrunde gelegt werden, dass die Polarisationseigenschaft des optischen Systems innerhalb des Messfeldes keine messrelevante Variation aufweist. Falls unterschiedliche Werte für den Polarisationsparameter ermittelt werden und damit doch eine messrelevante Variation der Polarisationseigenschaft des optischen Systems vorliegen, kann diese Variation bei der Auswertung des Messergebnisses zukünftiger Polarisationsparametermessungen entsprechend berücksichtigt werden.

Gemäß einer weiteren Ausführungsform ist das Beleuchtungssystem dazu konfiguriert, die optische Strahlung in einem linear polarisierten Zustand bereitzustellen.

Weiterhin wird erfindungsgemäß eine Projektionsbelichtungsanlage für die Mikrolithographie bereitgestellt, welche ein Projektionsobjektiv sowie eine Messvorrichtung in einer der vorstehend beschriebenen Ausführungsformen aufweist, wobei hierbei die Messvorrichtung zum Bestimmen eines Polarisationsparameters des Projektionsobjektivs konfiguriert ist. Hierbei ist vorzugsweise das Beleuchtungssystem der Messvorrichtung identisch mit dem Beleuchtungssystem der Projektionsbelichtungsanlage.

Weiterhin wird erfindungsgemäß das nachstehende Verfahren zum Bestimmen eines Polarisationsparameters eines optischen Systems bereitgestellt. Bei diesem Verfahren wird eine Messmaske mit Messstrukturen, die an mehreren Feldpunkten der Messmaske angeordnet sind, bereitgestellt. Weiterhin wird eine optische Strahlung derart auf die Messmaske mit einem feldpunktabhängigen Polarisationsmuster eingestrahlt, dass zum gleichen Zeitpunkt einer der Feldpunkte mit der optischen Strahlung in einem ersten Polarisationszustand und ein weiterer der Feldpunkte mit der optischen Strahlung in einem zweiten Polarisationszustand bestrahlt wird. Weiterhin wird die optische Strahlung nach Wechselwirkung mit der Messmaske sowie darauf erfolgter Wechselwirkung mit dem optischen System erfasst, und aus der erfassten optischen Strahlung wird der optische Parameter des optischen Systems ermittelt, wobei die Messstrukturen in mehreren Messfeldern angeordnet sind und der Polarisationszustand der auf die Messmaske eingestrahlten optischen Strahlung innerhalb jedes der Messfelder mit dem gleichen Variationsmuster feldpunktabhängig variiert wird.

Gemäß einer Ausführungsform wird das erfindungsgemäße Verfahren der Messvorrichtung in einer der vorstehend beschriebenen Ausführungsformen durchgeführt.

Gemäß einer weiteren Ausführungsform des erfindungsgemäßen Verfahrens werden bei der Bestimmung des Polarisationsparameters des optischen Systems Orientierungszernikekoeffizienten des optischen Sytstems aus der erfassten optischen Strahlung bestimmt. Aus den Orientierungszernikekoeffizienten wird daraufhin der Polarisationsparameter ermittelt. Die Definition von Orientierungszernikekoeffizienten wird im Rahmen der Figurenbeschreibung näher dargelegt.

Die bezüglich der vorstehend aufgeführten Ausführungsformen, Ausführungsbeispiele bzw. Ausführungsvarianten, etc. der erfindungsgemäßen Messvorrichtung angegebenen Merkmale können entsprechend auf das erfindungsgemäße Verfahren übertragen werden. Umgekehrt können die bezüglich der vorstehend ausgeführten Ausführungsformen, Ausführungsbeispiele bzw. Ausführungsvarianten des erfindungsgemäßen Verfahrens angegebenen Merkmale entsprechend auf die erfindungsgemäße Messvorrichtung übertragen werden. Diese und andere Merkmale der erfindungsgemäßen Ausführungsformen werden in der Figurenbeschreibung und den Ansprüchen erläutert. Die einzelnen Merkmale können entweder separat oder in Kombination als Ausführungsformen der Erfindung verwirklicht werden. Weiterhin können sie vorteilhafte Ausführungsformen beschreiben, die selbstständig schutzfähig sind und deren Schutz ggf. erst während oder nach Anhängigkeit der Anmeldung beansprucht wird.

### Kurzbeschreibunq der Zeichnungen

Die vorstehenden, sowie weitere vorteilhafte Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:
Fig. 1 eine Ausführungsform einer erfindungsgemäßen Messvorrichtung zum Bestimmen eines Polarisationsparameters eines optischen Systems mit einer Messmaske sowie einer Polarisationsvariationseinrichtung,
Fig. 2 eine jeweils erste Ausführungsform der Messmaske sowie der Polarisationsvariationseinrichtung, sowie
Fig. 3 eine jeweils zweite Ausführungsform der Messmaske sowie der Polarisationsvariationseinrichtung.

### Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden.

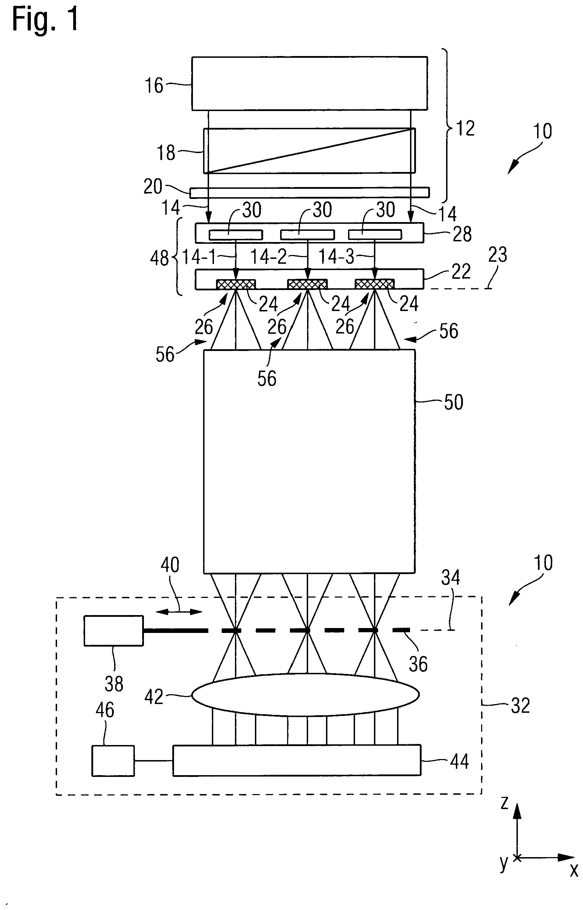

Zur Erleichterung der Beschreibung ist in der Zeichnung ein kartesisches xyz-Koordinatensystem angegeben, aus dem sich die jeweilige Lagebeziehung der in den Figuren dargestellten Komponenten ergibt. In Fig. 1 verläuft die y-Richtung senkrecht zur Zeichenebene in diese hinein, die x-Richtung nach rechts und die z-Richtung nach oben.

Fig. 1 zeigt eine Ausführungsform einer erfindungsgemäßen Messvorrichtung 10 zum Bestimmen eines Polarisationsparameters eines optischen Systems 50 in Gestalt eines Projektionsobjektives einer Projektionsbelichtungsanlage für die Mikrolithographie. Das optische System 50 kann zum Beispiel auf eine Betriebswellenlänge im UV-Wellenlängenbereich, wie etwa 248 nm oder 193 nm, oder auch auf eine Betriebswellenlänge im EUV-Wellenlängenbereich, wie etwa 13,5 nm oder 6,8 nm, ausgelegt sein. Im Fall einer EUV-Betriebswellenlänge umfasst das optische System 50 lediglich reflektive optische Elemente in Gestalt von Spiegeln.

Die Messvorrichtung 10 ist in der gezeigten Ausführungsform als Scherinterferometer konfiguriert und umfasst dazu ein Beleuchtungssystem 12, eine Polarisationsvariationseinrichtung 28, eine Messmaske 22 sowie ein Erfassungsmodul 32. Die Messvorrichtung 10 kann als eine von dem optischen System 50 unabhängige Messanordnung konfiguriert sein. Alternativ kann die Messvorrichtung 10 auch in eine Projektionsbelichtungsanlage für die Mikrolithographie integriert sein, welche das optische System 50 in Gestalt eines Projektionsobjektivs umfasst. In diesem Fall sind vorzugweise das Beleuchtungssystem 12 sowie das Erfassungsmodul 32 Teil der Projektionsbelichtungsanlage. Die Polarisationsvariationseinrichtung 28 und die Messmaske 22 können in einem Messretikel 48 integriert sein, welches zur Durchführung des Messvorgangs in die Maskenebene der Projektionsbelichtungsanlage geladen wird.

Nachfolgend wird die Messvorrichtung 10 als eine von dem optischen System 50 unabhängige Messanordnung beschrieben. Das Beleuchtungssystem 12 strahlt optische Strahlung 14 in der Betriebswellenlänge des optischen Systems 50 in einem definierten Polarisationszustand auf die Polarisationsvariationseinrichtung 28 ein. Dazu umfasst das Beleuchtungssystem 12 einer Strahlungsquelle 16 in Gestalt eines Lasers, einen Polarisator 18 sowie eine Polarisationsdreheinrichtung 20. Die Strahlungsquelle 16 erzeugt die optische Strahlung 14 mit einem bereits hohen Polarisationsgrad. Der polarisierte Anteil der von der Strahlungsquelle 16 erzeugten optischen Strahlung 14 wird mittels des Polarisators 18 abgetrennt. Dieser polarisierte Anteil kann durch die Polarisationsdreheinrichtung 20 gedreht werden. Die Polarisationsdreheinrichtung 20 kann eine drehbare Halbwellenplatte oder ein mit Rotatoren besetztes Magazin, die nacheinander in den Strahlengang der optischen Strahlung 14 gebracht werden können, umfassen.

Gemäß einer Ausführungsform ist die Polarisationsvariationseinrichtung 28 ortsfest an der Oberseite der Messmaske 22 befestigt, sodass die Polarisationseinrichtung 28 und die Messmaske 22 ein zusammenhängendes Messretikel 48 bilden. Alternativ kann die Polarisationsvariationseinrichtung 28 auch als separates Element ausgeführt sein und an einer geeigneten Position im Strahlengang der auf die Messmaske eingestrahlten optischen Strahlung 14 angeordnet sein.

In der hier beschriebenen Ausführungsform dient die Messvorrichtung 10 zur Bestimmung der feldaufgelösten Retardation des optischen Systems 50.

Alternativ kann der zu bestimmende Polarisationsparameter aber auch den linearen Dichroismus, die Rotation, den Zirkulardichroismus oder auch die Polarisationsabhängigkeit eines Verzeichnungsfehlers oder eines Fokuslagenfehlers des optischen Systems 50 betreffen.

Zur genannten Bestimmung der feldaufgelösten Retardation werden der Polarisator 18 und die Polarisationsdreheinrichtung 20 derart eingestellt, dass die auf die Polarisationseinrichtung 28 eingestrahlte optische Strahlung 14 in einem linearen Polarisationszustand mit einer vorgegebenen Polarisationsrichtung vorliegt. In der nachfolgenden beispielhaften Beschreibung wird für die auf die Polarisationsvariationseinrichtung 28 eingestrahlte optische Strahlung 14 ein in x-Richtung linear polarisierter Zustand, welcher mit dem Jones-Vektor $\left(\begin{matrix}1 \\ 0\end{matrix}\right)$ beschrieben wird, gewählt.

Die Polarisationsvariationseinrichtung 28 weist eine Vielzahl von Polarisationsmanipulationselementen 30 in Gestalt von unterschiedlich orientierten Halbwellenplatten auf. Alternativ können als Polarisationsmanipulationselemente 30 auch Module mit optisch aktiven Substanzen zur Drehung der Polarisationsrichtung oder für den Fall, in dem die Rotation oder der Zirkulardichroismus als Polarisationsparameter bestimmt werden soll, beispielsweise auch Viertelwellenplatten zum Einsatz kommen. Die eingestrahlte optische Strahlung 14 weist nach Durchtritt durch die Polarisationselemente 30 unterschiedliche Polarisationszustände auf, sodass unterschiedliche Feldpunkte 26 der Messmaske 22 mit optischer Strahlung 14-1, 14-2, 14-3 unterschiedlicher Polarisationszustände bestrahlt wird, wie in Fig. 1 veranschaulicht.

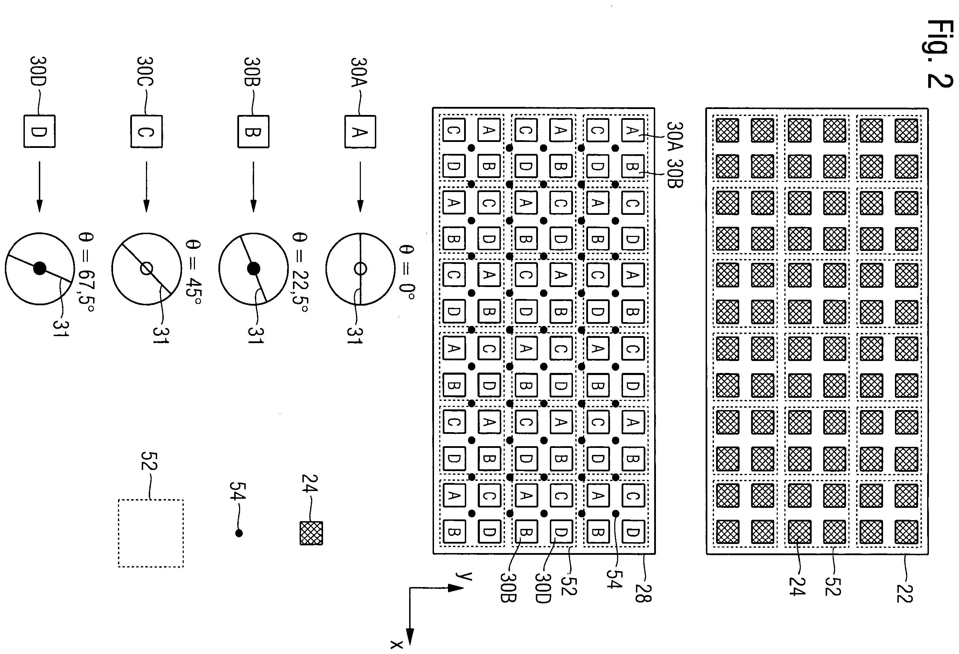

Die Messmaske 22 ist unterhalb der Polarisationsvariationseinrichtung 28 in einer Objektebene 23 des optischen Systems 50 angeordnet. An den vorstehend genannten Feldpunkten 26 der Messmaske 22 sind Messstrukturen 24 angeordnet. Die Messstrukturen 24 weisen jeweils eine Gitterstruktur auf und können z.B. als Schachbrettgitter oder als Liniengitter konfiguriert sein. Eine derartige Messmaske 22 ist grundsätzlich auch unter dem Begriff "Kohärenzmaske" bekannt. Fig. 2 veranschaulicht eine erste Ausführungsform einer solchen Messmaske 22 zusammen mit einer daran angepassten Polarisationsvariationseinrichtung 28.

Die Messmaske gemäß Fig. 2 weist ein gleichmäßiges x/y-Raster an über das gesamte Feld der Messmaske 22 verteilten Messstrukturen 24 auf. Zum Zweck der nachstehenden Erläuterung sind die Messstrukturen 24 in Messfelder 52 eingeteilt. Diese Messfelder 52 sind nicht unbedingt physisch auf der Messmaske gekennzeichnet. In den genannten Messfeldern 52 sind jeweils vier Messstrukturen 24, und zwar in einer Matrix aus zwei Zeilen und zwei Spalten, angeordnet.

Die im Strahlengang oberhalb der Messmaske 22 angeordnete Polarisationsvariationseinrichtung 28 weist ein an das Raster der Messmaske 22 angepasstes Raster an Polarisationsmanipulationselementen 30 auf. Diese sind dabei in vier verschiedenen Varianten vorhanden, nämlich als Halbwellenplatten 30A, 30B, 30C und 30D. Bei der Halbwellenplatte 30A ist, wie in der Legende von Fig. 2 veranschaulicht, deren schnelle Achse 31 parallel zur in x-Richtung linear polarisierten eingestrahlten Strahlung 14 ausgerichtet, d.h. der Drehwinkel θ beträgt 0°. Für die Halbwellenplatte 30B gilt: θ=22,5°, für die Halbwellenplatte 30C: θ=45° sowie für die Halbwellenplatte 30D: θ=67,5°.

Der Polarisationszustand der optischen Strahlung 14 ist nach Durchtritt durch eine der Halbwellenplatten 30A weiterhin unverändert (Jones-Vektor: $\left(\begin{matrix}1 \\ 0\end{matrix}\right) ,$ nachstehend Polarisationszustand A bezeichnet), nach Durchtritt durch eine der Halbwellenplatten 30B um 45° gedreht (Jones-Vektor: $\frac{1}{\sqrt{2}} \left(\begin{matrix}1 \\ 1\end{matrix}\right) ,$ nachstehend Polarisationszustand B bezeichnet), nach Durchtritt durch eine der Halbwellenplatten 30C um 90° gedreht (Jones-Vektor: $\left(\begin{matrix}0 \\ 1\end{matrix}\right) ,$ nachstehend Polarisationszustand C bezeichnet), sowie nach Durchtritt durch eine der Halbwellenplatten 30D um 135° gedreht (Jones-Vektor: $\frac{1}{\sqrt{2}} \left(\begin{matrix}1 \\ - 1\end{matrix}\right) ,$_{\} nachstehend Polarisationszustand D bezeichnet).

Jede der Messstrukturen 24 definiert einen eigenen Messkanal 56 durch das optische System 50, wie in Fig. 1 veranschaulicht. Als Messkanäle werden die jeweiligen optischen Strahlengänge durch das optische System 50 bezeichnet. Da die von einer jeweiligen Messstruktur 24 ausgehende optische Strahlung 14 auf jeweils einem eigenen optischen Strahlengang durch das optische System 50 verläuft, können feldpunktabhängige Variationen von optischen Fehlern des optischen Systems 50 durch feldpunktabhängige Auswertung der optischen Strahlung 14 nach Durchtritt durch das optische System 50 ermittelt werden.

In der Ausführungsform gemäß Fig. 2 sind die Messkanäle 56 entsprechend der Einteilung der Messstrukturen 24 in die Messfelder 52 jeweils in Vierergruppen zusammengefasst, wobei die Messkanäle 56 jeder Vierergruppe in jeweils unterschiedlichen Polarisationszuständen betrieben werden, und zwar in den vorstehend bezeichneten Polarisationszuständen A, B, C und D.

Mit dem Erfassungsmodul 32 wird, wie nachstehend näher erläutert, für jeden der Messkanäle 56 eine durch das optische System 50 erzeugte Wellenfrontabweichung ermittelt. Durch Auswertung der Messergebnisse der jeweiligen zu einem Messfeld 52 zusammengefassten Messkanäle 56 kann der Polarisationsparameter der Retardation für den Ort des Messfeldes 52 berechnet werden. Dieser Ort wird als Messpunkt 54 bezeichnet und ist in Fig. 2 in der graphischen Veranschaulichung der Polarisationsvariationseinrichtung 28 für jedes der Messfelder 52 veranschaulicht. Der jeweilige Messpunkt 54 liegt im jeweiligen Zentrum der eine Vierergruppe an Messstrukturen 24 umfassenden Messfelder 52 und damit jeweils im Zentrum einer Vierergruppe von mit den Polarisationszuständen A, B, C und D betriebenen Messkanälen 56.

Weiterhin können jedoch auch weitere, in Fig. 2 nicht eingezeichnete, Messfelder definiert werden, die jeweils eine zwei Zeilen und zwei Spalten umfassende Vierergruppe an Messkanälen mit den Polarisationszuständen A, B, C und D, umfassen. Im jeweiligen Zentrum dieser weiteren Messfelder werden weitere, in Fig. 2 eingezeichnete, Messpunkte 54 definiert. Die Retardation am Ort dieser weiteren Messpunkte 54 wird entsprechend durch Auswertung der Wellenfrontmessergebnisse an den Orten der sie umgebenden Messkanäle 56 mit den Polarisationszuständen A, B, C und D ermittelt. Im Ergebnis kann damit die Retardation mit einer Feldauflösung ermittelt werden, die der Dichte der Messstrukturen 24 bzw. der Dichte der Messkanäle 56 entspricht.

Zur vorstehend beschriebenen feldaufgelösten Messung der Retardation umfasst das Erfassungsmodul 32, wie in Fig. 1 dargestellt, ein in der der Objektebene 23 zugeordneten Bildebene 34, angeordnetes Beugungsgitter 36 sowie eine Verschiebeeinrichtung 38. Das Beugungsgitter 36 wird von der Verschiebeeinrichtung 38 während des Messvorgangs in zumindest einer Bewegungsrichtung 40 verschoben, optional auch in zwei zueinander orthogonalen Bewegungsrichtungen. Diese Verschiebung wird auch "Phasenschieben" genannt und erfolgt in n Schritten. Die am Beugungsgitter 36 erzeugten Wellen werden auf einen zweidimensional ortsauflösenden Detektor 44, optional mittels einer Kondensoroptik 42, abgebildet. Mittels des Detektors 44 werden die in den einzelnen Schritten auf der Detektoroberfläche erzeugten Interferogramme aufgezeichnet. Mittels einer Auswerteeinheit 46 werden die Ableitungen der Wellenfront berechnet. Durch Integration der Ableitungen wird daraufhin die Wellenfront der optischen Strahlung 14 nach Durchlaufen des optischen Systems 50 für jeden der Feldpunkte 26 berechnet.

Für jedes Messfeld 52 liegen nun vier Wellenfronten Φ vor, und zwar Φ(0°) für den Messkanal 56 mit dem Polarisationszustand A (um 0° gedreht gegenüber der Eingangspolarisation), Φ(45°) für den Messkanal 56 mit dem Polarisationszustand B (um 45° gedreht gegenüber der Eingangspolarisation), Φ(90°) für den Messkanal 56 mit dem Polarisationszustand C (um 90° gedreht gegenüber der Eingangspolarisation sowie Φ(135°) für den Messkanal 56 mit dem Polarisationszustand D (um 135° gedreht gegenüber der Eingangspolarisation).

Für jede der Wellenfronten Φ(0°), Φ(45°), Φ(90°) sowie Φ(135°) führt nun die Auswerteeinheit 46 eine Zernike-Polynomzerlegung durch. Eine derartige Zernike-Polynomzerlegung ist dem Fachmann beispielsweise aus Kapitel 13.2.3 des Lehrbuchs "Optical Shop Testing", 2nd Edition (1992) von Daniel Malacara, Hrsg. John Wiley & Sons, Inc. bekannt. Nachstehend werden die aus der Zernike-Polynomzerlegung erhaltenen Zernike-Polynome gemäß der sogenannten "Fringe"-Sortierung bezeichnet. Die "Fringe"-Sortierung der Zernike-Polynome Zⱼ ist die beispielsweise in Tabelle 20-2 auf Seite 215 des "Handbook of Optical Systems", Vol. 2 von H. Gross, 2005 Wiley-VCH Verlag GmbH & Co. KGaA, Weinheim veranschaulicht. Eine Wellenfront W(ρ,ϕ) an einem Punkt in der Objektebene 23 wird dann wie folgt entwickelt: $W \left(ρ, φ\right) = {\sum }_{j} {c}_{j} ⋅ {Z}_{j} \left(ρ, φ\right)$

Während die Zernike-Polynome, auch Zernike-Funktionen bezeichnet, mit Z_{j,}, d.h. mit tiefergestelltem Index j, bezeichnet werden, werden die Zernike-Koeffizienten cⱼ nachstehend, wie in der Fachwelt üblich, auch mit Zj, d.h. mit normal gestelltem Index j benannt. So werden beispielsweise die Zernike-Koeffizienten, welche die geometrische Verzeichnung in x- bzw. y-Richtung bezeichnen, als Z2 und Z3 benannt. Die geometrische Verzeichnung *̅V̅Z̅*̅ lässt sich wie folgt aus Z2, Z3 und der numerischen Apertur NA des optischen Systems 50 bestimmen, wobei *V̅Z̅.* Z2 und Z3 Funktionen der Feldpunktkoordinaten sind: $\vec{VZ} = - \frac{1}{NA} ⋅ \left[\begin{matrix}Z 2 \\ Z 3\end{matrix}\right]$

Nachfolgend werden die für die einzelnen Drehzustände ϕ der Eingangspolarisation gewonnenen Zernike-Koeffizienten mit *Zj_{ϕ}* bezeichnet, wie z.B. *Z*2_{0°} für den Zernike-Koeffizienten Z2 der für den Messkanal 56 mit dem Polarisationszustand A (0°-Polarisationsdrehung) gemessenen Wellenfront Φ(0°).

Gemäß der Veröffentlichung "Orientation Zernike Polynomials: A useful way to describe the polarization effects of optical imaging systems" von J. Ruoff, M. Totzeck in Journal of Microlithography, Microfabrication, and Microsystems, Juli 2009, vol. 8, no. 3, 031404 (22 pp) lassen sich die Orientierungszernikepolynome OZⱼ als Jones-Matrizen darstellen. Deren Einträge entsprechen polarisierten Wellenfrontabweichungen, beschrieben durch Zernikepolynome Zⱼ) Durch Messung der zugehörigen Zernikekoeffizienten Zj lassen sich die Orientierungszernikekoeffizienten OZj als Matrizen bestimmen. Die Gesamtretardation lässt sich als Reihe über die Orientierungszernikepolynome OZⱼ darstellen. Die Koeffizienten OZj dieser Reihen bestimmen sich über die polarisiert gemessenen Zernike-Koeffizienten *Zj_{ϕ}*, wie nachstehend anhand vonOrientierungszernikekoeffizienten niederer Ordnung, und zwar anhand der Ortientierungszernikekoeffizienten OZ2, OZ-2, OZ3 und OZ-3, beschrieben.

Es gilt: $OZ 2 + OZ - 2 = Z {2}_{0 °} - Z {2}_{90 °} = Δ Z {2}_{0 ° , 90 °}$ $OZ 2 - OZ - 2 = Z {3}_{45 °} - Z {3}_{135 °} = Δ Z {3}_{45 ° , 135 °}$ $OZ 3 + OZ - 3 = Z {3}_{0 °} - Z {3}_{90 °} = Δ Z {3}_{0 ° , 90 °}$ $OZ 3 - OZ - 3 = Z {2}_{45 °} + Z {2}_{135 °} = - Δ Z {2}_{45 ° , 135 °}$

Daraus folgt für die Orientierungszernikekoeffizienten OZ2, OZ-2, OZ3 sowie OZ-3: $OZ 2 = 1 / 2 ⋅ \left(ΔZ{2}_{0 ° , 90 °}+ΔZ{3}_{45 ° , 135 °}\right)$ $OZ - 2 = 1 / 2 ⋅ \left(ΔZ{2}_{0 ° , 90 °}-ΔZ{3}_{45 ° , 135 °}\right)$ $OZ 3 = 1 / 2 ⋅ \left(ΔZ{3}_{0 ° , 90 °}-ΔZ{2}_{45 ° , 135 °}\right)$ $OZ - 3 = 1 / 2 ⋅ \left(ΔZ{3}_{0 ° , 90 °}+ΔZ{2}_{45 ° , 135 °}\right)$

Analog werden auch Orientierungszernikekoeffizienten höherer Ordnung berechnet. Aus den derart berechneten Orientierungszemikoeffizienten OZ±2/±3/±4 wird die Retardation am betreffenden Messpunkt 54 ermittelt. Analog wird bezüglich aller weiteren in Fig. 2 dargestellten Messpunkte vorgegangen. Grundsätzlich können die Polarisationseigenschaften des optischen Systems 50 Schwankungen durch zeitlich veränderliche Umweltbedingungen ausgesetzt sein. Durch die zeitgleiche Messung der Wellenfronten für die verschiedenen Polarisationszustände können Einflüsse derartiger Schwankungen in den Polarisationseigenschaften des optischen Systems 50 auf die Orientierungszernikekoeffizienten ausgeschlossen werden.

Zur Kalibrierung der Messvorrichtung wird die auf die Polarisationsvariationseinrichtung 28 eingestrahlte optische Strahlung 14 in weiteren Polarisationszuständen bereitgestellt und die vorstehend beschriebene Wellenfrontmessung am optischen System 50 für jeden dieser Polarisationszustände durchgeführt. So kann beispielsweise die eingestrahlte optische Strahlung 14 zusätzlich zum vorstehend gewählten Polarisationszustand $\left(\begin{matrix}1 \\ 0\end{matrix}\right)$ auch nacheinander mit den folgenden Eingangs-Polarisationszuständen bereitgestellt werden: $\frac{1}{\sqrt{2}} \left(\begin{matrix}1 \\ 1\end{matrix}\right) ,$ $\left(\begin{matrix}0 \\ 1\end{matrix}\right) ,$ $\frac{1}{\sqrt{2}} \left(\begin{matrix}1 \\ - 1\end{matrix}\right) .$

Nach Durchtritt durch die Halbwellenplatten 30A, 30B, 30C und 30D der Polarisationsvariationseinrichtung 28 ergeben sich daraufhin für die einzelnen Ausgangs-Polarisationszustände A, B, C, D die in Tab. 1 aufgeführten Drehwinkel bzw. Jones-Vektoren. Wie aus der Tabelle ersichtlich, wird jeder der vier durch die Halbwellenplatten 30A, 30B, 30C und 30D definierten Messkanäle 56 eines Messfeldes 52 mit jedem der vier linearen Polarisationszustände $\left(\begin{matrix}1 \\ 0\end{matrix}\right) ,$ $\frac{1}{\sqrt{2}} \left(\begin{matrix}1 \\ 1\end{matrix}\right) ,$ $\left(\begin{matrix}0 \\ 1\end{matrix}\right)$ sowie $\frac{1}{\sqrt{2}} \left(\begin{matrix}1 \\ - 1\end{matrix}\right) ,$ d.h. mit den linearen Polarisationszuständen der Orientierungsrichtungen 0°, 45°, 90° uns 135° beaufschlagt.

Durch Vergleich der Messergebnisse für die Retardation bei Einstrahlung der vier verschiedenen Eingangspolarisationszustände kann überprüft werden, ob die Messvorrichtung 10 polarisationsunabhängig ist. Falls dies der Fall ist, sollte die bezüglich der einzelnen Messpunkte 54 gemessene Retardation unabhängig vom Eingangspolarisationszustand sein. Im Fall, in dem Abweichungen in der Retardation bei Verwendung unterschiedlicher Eingangspolarisationszustände gemessen werden, können diese Abweichungen zur Kalibrierung der Messvorrichtung 10 verwendet werden und bei der Auswertung zukünftiger Messungen von der Auswerteeinheit 46 entsprechend berücksichtigt werden.

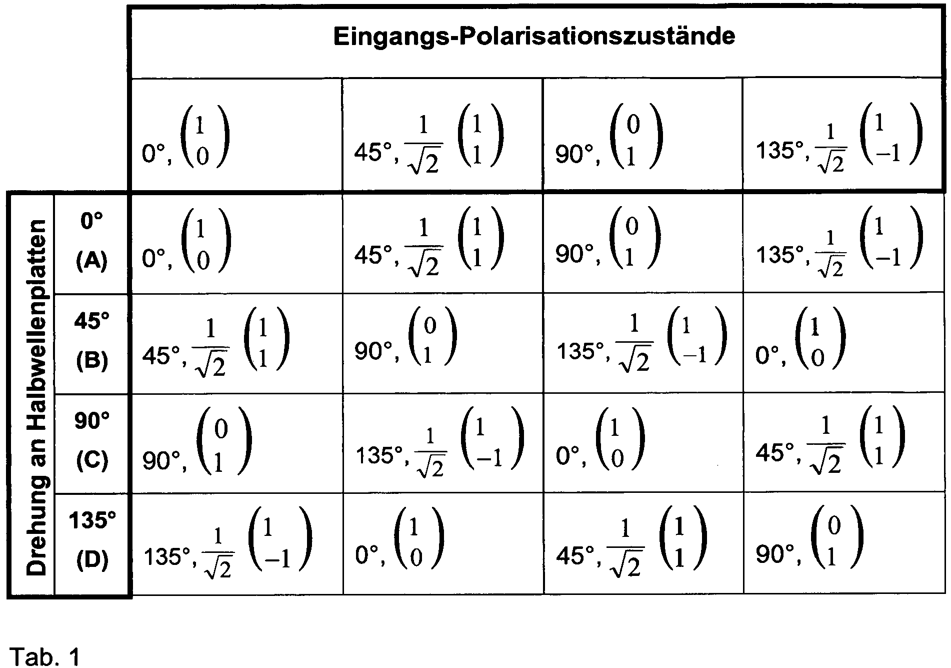

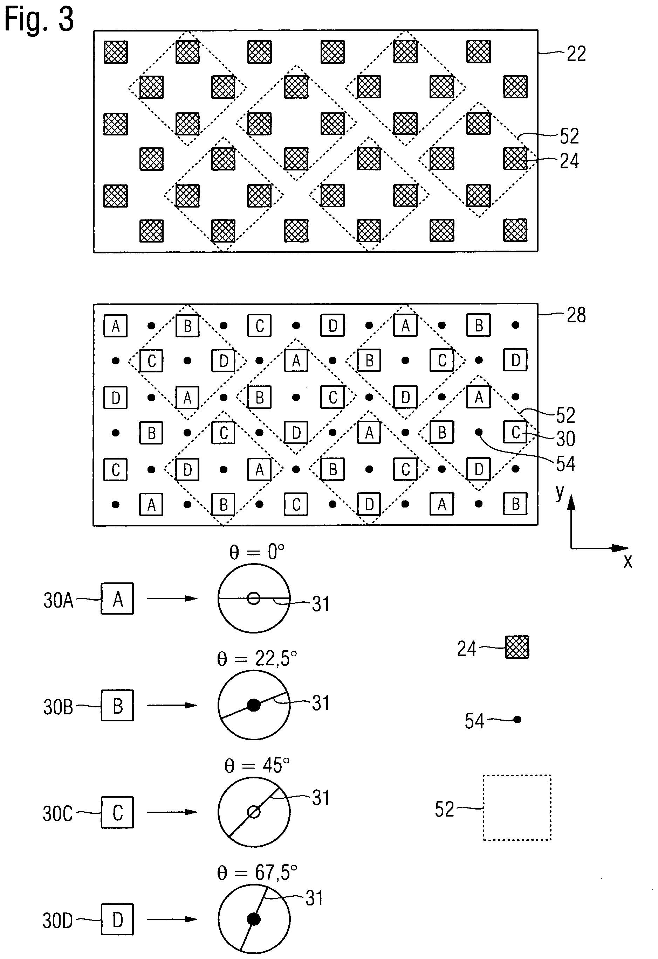

Fig. 3 zeigt eine weitere Ausführungsform einer Messmaske 22 sowie einer daran angepassten Polarisationsvariationseinrichtung 28. Diese unterscheidet sich dahingehend von der Ausführungsform gemäß Fig. 2, dass die Messstrukturen 24 anstatt in einem gleichmäßigen x/y-Raster in einem rautenförmigen Muster angeordnet sind, in dem die Messstrukturen 24 jeweils entlang von schrägen Linien angeordnet sind. Die Polarisationselemente 30 auf der Polarisationsvariationseinrichtung 28 sind analog zum Muster der Messstrukturen 24 angeordnet. Auch in dieser Anordnung befinden sich die Messpunkte 54 im jeweiligen Zentrum einer Vierergruppe von mit den Polarisationszuständen A, B, C und D bestrahlten Messstrukturen 24, wie in Fig. 3 veranschaulicht.

In einer weiteren Ausführungsform der Messvorrichtung 10 wird, wie vorstehend bereits erwähnt, ein Verzeichnungsfehler des optischen Systems feldpunktabhängig auf seine Polarisationsabhängigkeit hin untersucht. Diese Ausführungsform unterscheidet sich von der in Fig. 1 gezeigten Ausführungsform dahingehend, dass die Messstrukturen 24 auf der Messmaske 22 nicht als Schachbrettmuster, sondern als Kreuze oder ähnliche Strukturen ausgeführt sind.

Weiterhin wird als Erfassungsmodul 32 anstatt des in Fig. 1 gezeigten Moduls lediglich ein mit Photolack beschichteter Wafer verwendet. Beim Messvorgang werden die vorstehend beschriebenen Messstrukturen 24 auf den Wafer abgebildet. Anschließend wird der belichtete Wafer unter einem geeigneten Mikroskop, wie etwa einem Elektronenmikroskop, durch Overlaymessung auf Verzeichnungsfehler hin untersucht. Als Ergebnis dieser Untersuchung wird die Polarisationsabhängigkeit eines Verzeichnungsfehlers des optischen Systems 50 an den einzelnen Feldpunkten ermittelt. Analog kann auch die Polarisationsabhängigkeit von Fokuslagenfehlern ermittelt werden.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen, insoweit sie in den Rahmen der Erfindung gemäß der Definition in den beigefügten Ansprüchen fallen, vom Schutz der Ansprüche abgedeckt sein.

### Bezugszeichenliste

- 10: Messvorrichtung
- 12: Beleuchtungssystem
- 14: optische Strahlung
- 16: Strahlungsquelle
- 18: Polarisator
- 20: Polarisationsdreheinrichtung
- 22: Messmaske
- 23: Objektebene
- 24: Messstruktur
- 26: Feldpunkt
- 28: Polarisationsvariationseinrichtung
- 30: Polarisationsmanipulationselement
- 30A, 30B, 30C, 30D: Halbwellenplatten
- 31: schnelle Achse
- 32: Erfassungsmodul
- 34: Bildebene
- 36: Beugungsgitter
- 38: Verschiebeeinrichtung
- 40: Bewegungsrichtung
- 42: Kondensoroptik
- 44: Detektor
- 46: Auswerteeinheit
- 48: Messretikel
- 50: optisches System
- 52: Messfeld
- 54: Messpunkt
- 56: Messkanal

Die Ansprüche der Erfindung folgen nachstehend.

## Patentansprüche

1. Messvorrichtung (10) zum Bestimmen eines Polarisationsparameters eines optischen Systems (50), mit:
- einem Beleuchtungssystem (12) zum Bereitstellen einer optischen Strahlung,
- einer Messmaske (22), welche zwischen dem Beleuchtungssystem und dem optischen System angeordnet ist und Messstrukturen (24) aufweist, die an mehreren Feldpunkten (26) der Messmaske angeordnet sind,
- einer Polarisationsvariationseinrichtung (28), welche in einem Strahlengang der optischen Strahlung angeordnet ist und dazu konfiguriert ist, einen Polarisationszustand der optischen Strahlung feldpunktabhängig zu variieren, sodass zum gleichen Zeitpunkt einer der Feldpunkte mit der optischen Strahlung in einem ersten Polarisationszustand und ein weiterer der Feldpunkte mit der optischen Strahlung in einem zweiten Polarisationszustand bestrahlt wird, sowie
- einem Erfassungsmodul (32), welches dazu konfiguriert ist, die optische Strahlung nach Wechselwirkung mit dem optischen System zu erfassen, **dadurch gekennzeichnet, dass** die Messstrukturen (24) in mehreren Messfeldern (52) angeordnet sind und die Polarisationsvariationseinrichtung dazu konfiguriert ist, den Polarisationszustand der optischen Strahlung innerhalb jedes der Messfelder mit dem gleichen Variationsmuster feldpunktabhängig zu variieren.

2. Messvorrichtung nach Anspruch 1,
bei der die Polarisationsvariationseinrichtung mindestens ein Polarisationsrotationselement zur Drehung der eingestrahlten optischen Strahlung aufweist.

3. Messvorrichtung nach einem der vorausgehenden Ansprüche,
bei der die Polarisationsvariationseinrichtung mindestens eine Halbwellenplatte aufweist.

4. Messvorrichtung nach einem der vorausgehenden Ansprüche,
bei der die Polarisationsvariationseinrichtung mindestens eine Viertelwellenplatte aufweist.

5. Messvorrichtung nach einem der vorausgehenden Ansprüche,
bei der die Polarisationsvariationseinrichtung an der Messmaske befestigt ist.

6. Messvorrichtung nach einem der vorausgehenden Ansprüche,
welche als Wellenfrontmessvorrichtung konfiguriert ist.

7. Messvorrichtung nach einem der vorausgehenden Ansprüche, bei der das Erfassungsmodul ein Beugungsgitter umfasst.

8. Messvorrichtung nach einem der vorausgehenden Ansprüche,
bei der das Beleuchtungssystem dazu konfiguriert ist, die optische Strahlung nacheinander in unterschiedlichen Polarisationszuständen bereitzustellen.

9. Messvorrichtung nach einem der vorausgehenden Ansprüche,
bei der der das Beleuchtungssystem dazu konfiguriert ist, die optische Strahlung in einem linear polarisierten Zustand bereitzustellen.

10. Projektionsbelichtungsanlage für die Mikrolithographie mit einem Projektionsobjektiv sowie einer Messvorrichtung nach einem der vorausgehenden Ansprüche,
wobei die Messvorrichtung zum Bestimmen eines Polarisationsparameters des Projektionsobjektivs konfiguriert ist.

11. Verfahren zum Bestimmen eines Polarisationsparameters eines optischen Systems, bei dem:
- eine Messmaske mit Messstrukturen, die an mehreren Feldpunkten der Messmaske angeordnet sind, bereitgestellt wird,
- eine optische Strahlung derart auf die Messmaske mit einem feldpunktabhängigen Polarisationsmuster eingestrahlt wird, dass zum gleichen Zeitpunkt einer der Feldpunkte mit der optischen Strahlung in einem ersten Polarisationszustand und ein weiterer der Feldpunkte mit der optischen Strahlung in einem zweiten Polarisationszustand bestrahlt wird,
- die optische Strahlung nach Wechselwirkung mit der Messmaske sowie darauf erfolgter Wechselwirkung mit dem optischen System erfasst wird und aus der erfassten optischen Strahlung der Polarisationsparameter des optischen Systems ermittelt wird, **dadurch gekennzeichnet, dass** die Messstrukturen in mehreren Messfeldern angeordnet sind und der Polarisationszustand der auf die Messmaske eingestrahlten optischen Strahlung innerhalb jedes der Messfelder mit dem gleichen Variationsmuster feldpunktabhängig variiert wird.

12. Verfahren nach Anspruch 11,
welches mittels der Messvorrichtung nach einem der Ansprüche 1 bis 9 durchgeführt wird.

13. Verfahren nach Anspruch 11 oder 12.
bei dem bei der Bestimmung des Polarisationsparameters des optischen Systems Orientierungszernikekoeffizienten des optischen Systems aus der erfassten optischen Strahlung bestimmt werden.

## Claims

1. Measurement system (10) for determining a polarization parameter of an optical system (50), comprising:
- an illumination system (12) for providing optical radiation,
- a measurement mask (22), which is arranged between the illumination system and the optical system and comprises measurement structures (24) arranged at a plurality of field points (26) of the measurement mask,
- a polarization variation device (28), which is arranged in a beam path of the optical radiation and is configured to vary a polarization state of the optical radiation in a field-point-dependent manner, such that at the same point in time one of the field points is irradiated with the optical radiation in a first polarization state and another of the field points is irradiated with the optical radiation in a second polarization state, and
- a detection module (32), which is configured to detect the optical radiation after interaction with the optical system, **characterized in that** the measurement structures (24) are arranged in a plurality of measurement fields (52) and the polarization variation device is configured to vary the polarization state of the optical radiation within each of the measurement fields with the same variation pattern in a field-point-dependent manner.

2. Measurement system according to Claim 1,
wherein the polarization variation device comprises at least one polarization rotation element for rotating the radiated optical radiation.

3. Measurement system according to either of the preceding claims,
wherein the polarization variation device comprises at least one half-wave plate.

4. Measurement system according to any of the preceding claims,
wherein the polarization variation device comprises at least one quarter-wave plate.

5. Measurement system according to any of the preceding claims,
wherein the polarization variation device is fixed to the measurement mask.

6. Measurement system according to any of the preceding claims,
which is configured as a wavefront measurement system.

7. Measurement system according to any of the preceding claims,
wherein the detection module comprises a diffraction grating.

8. Measurement system according to any of the preceding claims,
wherein the illumination system is configured to provide the optical radiation successively in different polarization states.

9. Measurement system according to any of the preceding claims,
wherein the illumination system is configured to provide the optical radiation in a linearly polarized state.

10. Projection exposure apparatus for microlithography comprising a projection lens and a measurement system according to any of the preceding claims,
wherein the measurement system is configured for determining a polarization parameter of the projection lens.

11. Method for determining a polarization parameter of an optical system, wherein:
- a measurement mask comprising measurement structures arranged at a plurality of field points of the measurement mask is provided,
- optical radiation is radiated onto the measurement mask with a field-point-dependent polarization pattern in such a way that at the same point in time one of the field points is irradiated with the optical radiation in a first polarization state and another of the field points is irradiated with the optical radiation in a second polarization state,
- the optical radiation is detected after interaction with the measurement mask and subsequent interaction with the optical system and the polarization parameter of the optical system is determined from the detected optical radiation, **characterized in that** the measurement structures are arranged in a plurality of measurement fields and the polarization state of the optical radiation radiated onto the measurement mask is varied within each of the measurement fields with the same variation pattern in a field-point-dependent manner.

12. Method according to Claim 11,
which is carried out by means of the measurement system according to any of Claims 1 to 9.

13. Method according to Claim 11 or 12,
wherein, when determining the polarization parameter of the optical system, orientation Zernike coefficients of the optical system are determined from the detected optical radiation.

## Revendications

1. Dispositif de mesure (10) destiné à déterminer un paramètre de polarisation d'un système optique (50), ledit dispositif comprenant :
- un système d'éclairage (12) destiné à produire un rayonnement optique,
- un masque de mesure (22) qui est disposé entre le système d'éclairage et le système optique et qui comporte des structures de mesure (24) qui sont disposées en une pluralité de points de champ (26) du masque de mesure,
- une unité de variation de polarisation (28) qui est disposée dans un trajet de faisceau du rayonnement optique et qui est conçue pour faire varier un état de polarisation du rayonnement optique en fonction des points de champ de sorte que, au même instant, l'un des points de champ soit exposé au rayonnement optique dans un premier état de polarisation et un autre des points de champ soit exposé au rayonnement optique dans un deuxième état de polarisation, et
- un module de détection (32) qui est conçu pour détecter le rayonnement optique après interaction avec le système optique, **caractérisé en ce que** les structures de mesure (24) sont disposées dans une pluralité de champs de mesure (52) et l'unité de variation de polarisation est conçue pour faire varier l'état de polarisation du rayonnement optique dans chacun des champs de mesure avec le même motif de variation en fonction des points de champ.

2. Dispositif de mesure selon la revendication 1, dans lequel l'unité de variation de polarisation comporte au moins un élément de rotation de polarisation destiné à faire tourner le rayonnement optique incident.

3. Dispositif de mesure selon l'une des revendications précédentes, dans lequel l'unité de variation de polarisation comporte au moins une plaque demi-onde.

4. Dispositif de mesure selon l'une des revendications précédentes, dans lequel l'unité de variation de polarisation comporte au moins une plaque quart d'onde.

5. Dispositif de mesure selon l'une des revendications précédentes, dans lequel l'unité de variation de polarisation est fixée au masque de mesure.

6. Dispositif de mesure selon l'une des revendications précédentes, lequel est conçu comme un dispositif de mesure de front d'onde.

7. Dispositif de mesure selon l'une des revendications précédentes, dans lequel le module de détection comprend un réseau de diffraction.

8. Dispositif de mesure selon l'une des revendications précédentes, dans lequel le système d'éclairage est conçu pour produire le rayonnement optique successivement dans différents états de polarisation.

9. Dispositif de mesure selon l'une des revendications précédentes, dans lequel le système d'éclairage est conçu pour produire le rayonnement optique dans un état polarisé linéairement.

10. Système d'exposition par projection destiné à la microlithographie et comprenant un objectif de projection et un dispositif de mesure selon l'une des revendications précédentes,
le dispositif de mesure étant conçu pour déterminer un paramètre de polarisation de l'objectif de projection.

11. Procédé de détermination d'un paramètre de polarisation d'un système optique, procédé dans lequel :
- un masque de mesure est prévu qui est pourvu de structures de mesure disposées en plusieurs points de champ du masque de mesure,
- un rayonnement optique est incident au masque de mesure avec un motif de polarisation dépendant des points de champ de sorte que, au même instant, l'un des points de champ soit exposé au rayonnement optique dans un premier état de polarisation et un autre des points de champ soit exposé au rayonnement optique dans un deuxième état de polarisation,
- le rayonnement optique est détecté après interaction avec le masque de mesure et interaction ultérieure avec le système optique et le paramètre de polarisation du système optique est déterminé à partir du rayonnement optique détecté, **caractérisé en ce que** les structures de mesure sont disposées dans une pluralité de champs de mesure et l'état de polarisation du rayonnement optique incident au masque de mesure est amené à varier dans chacun des champs de mesure avec le même motif de variation en fonction des points de champ.

12. Procédé selon la revendication 11, qui est mis en œuvre au moyen du dispositif de mesure selon l'une des revendications 1 à 9.

13. Procédé selon la revendication 11 ou 12, dans lequel, lors de la détermination du paramètre de polarisation du système optique, des coefficients d'orientation Zernike du système optique sont déterminés à partir du rayonnement optique détecté.
